# EUROPEAN PATENT APPLICATION

(11) **EP 2 085 861 A1**
(43) Date of publication of application: **05.08.2009**
(21) Application number: 08150810.3
(22) Date of filing: 29.01.2008
(51) Int. Cl.: G06F 3/044

(54) **Electronic device and touch screen display**

(71) Applicant: Research In Motion Limited, Waterloo, Ontario N2L 3W8 (CA)
(72) Inventor: Ma, ZhongMing, Waterloo Ontario N2V 2A3 (CA)
(74) Representative: Rickard, David John

(57) **Abstract**

A touch screen display includes a display device, a resistive touch-sensitive overlay disposed on the display device and including a pair of touch-sensor layers separated by a gap, a resistive touch screen controller connected to each of the pair of touch-sensor layers for determining a position of a touch event on the touch-sensitive overlay and a capacitive controller connected to an outer one of the pair of touch-sensor layers for receiving input for determining changes resulting from capacitive coupling with the outer one of the pair of touch-sensor layers.

## Description

The present application relates generally to resistive touch screen devices.

Electronic devices, including portable electronic devices, have gained widespread use and can provide a variety of functions including, for example, telephonic, electronic messaging and other personal information manager (PIM) application functions. Portable electronic devices can include several types of devices including mobile stations such as simple cellular telephones, smart telephones, wireless PDAs, and laptop computers with wireless 802.11 or Bluetooth capabilities. These devices run on a wide variety of networks from data-only networks such as Mobitex and DataTAC to complex voice and data networks such as GSM/GPRS, CDMA, EDGE, UMTS and CDMA2000 networks.

Devices such as PDAs or smart telephones are generally intended for handheld use and easy portability. Smaller devices are generally desirable for portability. A touch screen input/output device is particularly useful on such handheld devices as such handheld devices are small and are therefore limited in space available for user input and output devices. Further, the screen content on the touch screen devices can be modified depending on the functions and operations being performed.

Touch screen devices are constructed of a display, such as a liquid crystal display, with a touch-sensitive overlay. Resistive touch-sensitive devices include a pair of touch-sensor layers with an outer one of the layers being flexed when pressed to contact the other one of the layers. The point of contact of the two layers is determined, thereby determining the location of the touch. Resistive touch-sensitive devices are particularly advantageous as they are relatively inexpensive by comparison to other touch-sensitive devices and support input from conductive and non-conductive input devices such as a stylus. These devices suffer from disadvantages, however. For example, resistive touch screen devices are limited to determination of x and y co-ordinates of a touch input and touch-events are not detected until there is contact between the two touch-sensor layers. Thus, the sensitivity of such touch screen devices is low and feedback can be slow.

Improvements in touch screen devices are therefore desirable.

### GENERAL

According to one aspect, there may be provided a touch screen display. The touch screen display may comprise a display device, a resistive touch-sensitive overlay disposed on the display device and including a pair of touch-sensor layers separated by a gap, a resistive touch screen control component connected to each of the pair of touch-sensor layers for determining a position of a touch event on the touch-sensitive overlay, and a capacitive control component connected to an outer one of the pair of touch-sensor layers for receiving input for determining changes resulting from capacitive coupling with the outer one of the pair of touch-sensor layers. The resistive touch screen control component can be a resistive touch screen controller and the capacitive control component can be a capacitive controller.

The touch screen display can comprise a host processor connected to the resistive touch screen control component and the capacitive control component.

The touch-sensor layers can comprise layers of ITO or any other suitable material disposed on respective substrates.

The outer one of the pair of touch-sensor circuit layers and the capacitive control component are configured to determine capacitive changes resulting from a conductive object proximal the resistive touch-sensitive overlay and spaced from the resistive touch-sensitive overlay by an air gap.

The touch screen display can comprise a protective cover on the outer touch-sensor layer.

The touch-sensitive overlay can be any suitable resistive touch-sensitive overlay including a four wire and a five wire resistive touch-sensitive overlay.

According to another aspect, an electronic device may be provided. The electronic device may comprise a base, a resistive touch screen display connected to the base and including a display device and a resistive touch-sensitive overlay disposed on the display device, and operational components disposed between the base and the touch screen display. The operational components may comprise a resistive touch screen control component connected to each of a pair of touch-sensor layers of the touch-sensitive overlay, a capacitive control component connected to an outer one of the pair of touch-sensor layers for receiving input for determining changes resulting from capacitive coupling, and a processor connected to the control component and the display device for providing a graphical user interface.

According to another aspect, there may be provided a method of controlling an electronic device having a resistive touch screen display. The method may comprise determining an object is proximal the touch screen display as a result of capacitive coupling between the object and an outer touch-sensor layer of the touch screen display, and effecting a change in the output of the portable electronic device in response to determining the object is proximal the touch screen display.

The change in the output can comprise a change in the displayed output on the resistive touch screen display.

Advantageously, a touch of the touch screen display can be detected prior to contact with the touch-screen display. Thus, a signal can be sent to the processor for providing a timely response when the touch screen is touched. For example, a tactile feedback can be provided more quickly providing a better user feel. When the touch screen is used in an electronic device, an output change can be effected based on the detection of a finger or conductive object held by a user, proximal the touch screen. For example, an LCD display screen can be turned off when the user puts the device near their face if, for example, done when a call is placed. Further, the LCD display screen can "wake up" if it is off when the object or finger approach the portable electronic device.

### BRIEF DESCRIPTION OF THE DRAWINGS

Embodiments of the present application will now be described, by way of example only, with reference to the attached Figures, wherein:

Figure 1 is a simplified block diagram of components of a touch screen display according an aspect of an embodiment

Figure 2 is a simplified sectional side view of a resistive touch screen display according to an aspect of an embodiment;

Figure 3 is a block diagram of certain components, including certain internal components of a portable electronic device according to one embodiment;

Figure 4 is a flow chart illustrating steps in a method of controlling an electronic device according to an aspect of an embodiment;

Figure 5 is a simplified block diagram of components of a touch screen display according an aspect of another embodiment.

### DESCRIPTION OF PREFERRED EMBODIMENTS

It will be appreciated that for simplicity and clarity of illustration, where considered appropriate, reference numerals may be repeated among the figures to indicate corresponding or analogous elements. In addition, numerous specific details are set forth in order to provide a thorough understanding of the embodiments described herein. However, it will be understood by those of ordinary skill in the art that the embodiments described herein may be practiced without these specific details. In other instances, well-known methods, procedures and components have not been described in detail so as not to obscure the embodiments described herein. Also, the description is not to be considered as limiting the scope of the embodiments described herein.

The embodiments described herein generally relate to a touch screen display and to a portable electronic device including a touch screen display. Examples of portable electronic devices include mobile, or handheld, wireless communication devices such as pagers, cellular phones, cellular smart-phones, wireless organizers, personal digital assistants, wirelessly enabled notebook computers and the like.

The portable electronic device may be a two-way communication device with advanced data communication capabilities including the capability to communicate with other portable electronic devices or computer systems through a network of transceiver stations. The portable electronic device may also have the capability to allow voice communication. Depending on the functionality provided by the portable electronic device, it may be referred to as a data messaging device, a two-way pager, a cellular telephone with data messaging capabilities, a wireless Internet appliance, or a data communication device (with or without telephony capabilities). The portable electronic device may also be a portable device without wireless communication capabilities as a handheld electronic game device, digital photograph album, digital camera and the like.

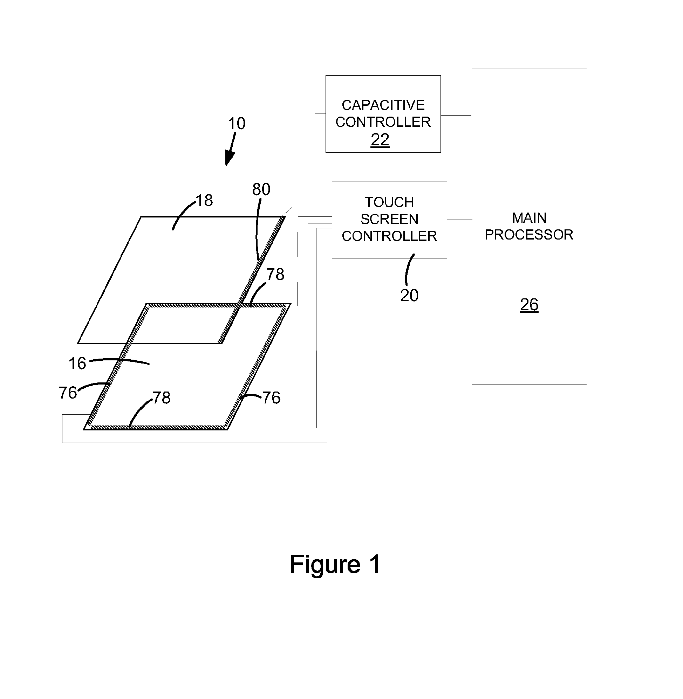

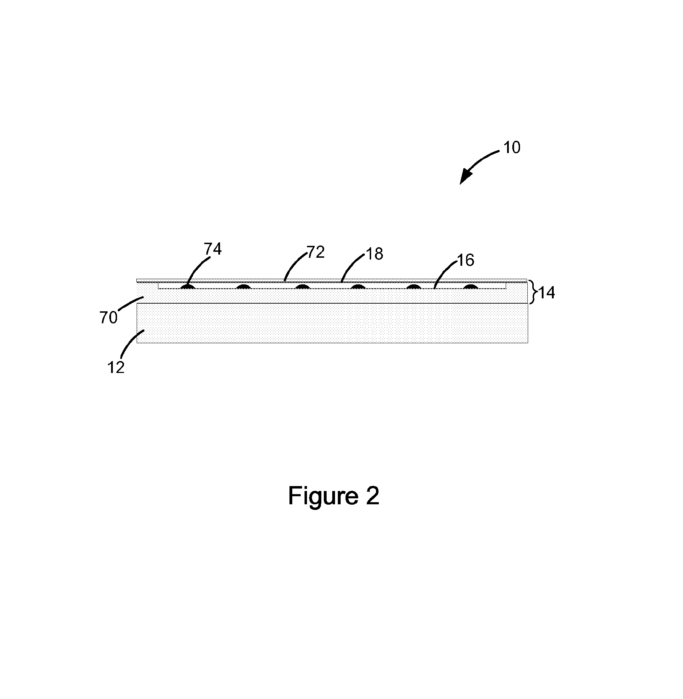

Reference is first made to Figures 1 and 2, which show components of a touch screen display according to an exemplary embodiment of the present application. The touch screen display is indicated generally by the numeral 10 and includes a display device 12, a resistive touch-sensitive overlay 14 disposed on the display device and including a pair of touch-sensor layers 16, 18 separated by a gap, a resistive touch screen control component, which in the present embodiment is a resistive touch screen controller 20 connected to each of the pair of touch-sensor layers 16, 18 for determining a position of a touch event on the touch-sensitive overlay and a capacitive control component, which in the present embodiment is a capacitive controller 22 connected to an outer one 18 of the pair of touch-sensor layers for receiving input for determining changes resulting from capacitive coupling with the outer one 18 of the pair of touch-sensor layers.

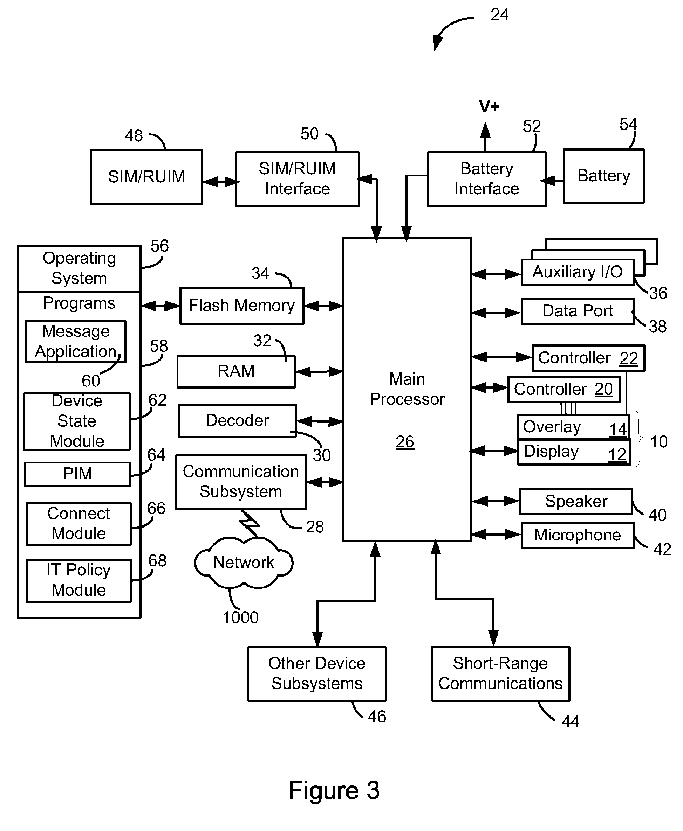

According to the present embodiment, the touch screen display is part of a portable electronic device. Referring now to Figure 3, there is shown therein a block diagram of an exemplary embodiment of a portable electronic device 24. The portable electronic device 24 includes a number of components such as the processor 26 that controls the overall operation of the portable electronic device 24. Communication functions, including data and voice communications, are performed through a communication subsystem 28. Data received by the portable electronic device 24 can be decompressed and decrypted by a decoder 30, operating according to any suitable decompression techniques (e.g. YK decompression, and other known techniques) and encryption techniques (e.g. using an encryption technique such as Data Encryption Standard (DES), Triple DES, or Advanced Encryption Standard (AES)). The communication subsystem 28 receives messages from and sends messages to a wireless network 1000. In this exemplary embodiment of the portable electronic device 24, the communication subsystem 28 is configured in accordance with the Global System for Mobile Communication (GSM) and General Packet Radio Services (GPRS) standards. The GSM/GPRS wireless network is used worldwide and it is expected that these standards will be superseded eventually by Enhanced Data GSM Environment (EDGE) and Universal Mobile Telecommunications Service (UMTS). New standards are still being defined, but it is believed that they will have similarities to the network behavior described herein, and it will also be understood by persons skilled in the art that the embodiments described herein are intended to use any other suitable standards that are developed in the future. The wireless link connecting the communication subsystem 28 with the wireless network 1000 represents one or more different Radio Frequency (RF) channels, operating according to defined protocols specified for GSM/GPRS communications. With newer network protocols, these channels are capable of supporting both circuit switched voice communications and packet switched data communications.

Although the wireless network 1000 associated with portable electronic device 24 is a GSM/GPRS wireless network in one exemplary implementation, other wireless networks may also be associated with the portable electronic device 24 in variant implementations. The different types of wireless networks that may be employed include, for example, data-centric wireless networks, voice-centric wireless networks, and dual-mode networks that can support both voice and data communications over the same physical base stations. Combined dual-mode networks include, but are not limited to, Code Division Multiple Access (CDMA) or CDMA2000 networks, GSM/GPRS networks (as mentioned above), and future third-generation (3G) networks like EDGE and UMTS. Some other examples of data-centric networks include WiFi 802.11, Mobitex™ and DataTAC™ network communication systems. Examples of other voice-centric data networks include Personal Communication Systems (PCS) networks like GSM and Time Division Multiple Access (TDMA) systems. The processor 26 also interacts with additional subsystems such as a Random Access Memory (RAM) 32, a flash memory 34, the touch screen display 10 including the display device 12 and the touch-sensitive overlay 14 connected to the resistive touch screen controller 20 and the capacitive touch screen controller 22, an auxiliary input/output (I/O) subsystem 36, a data port 38, a speaker 40, a microphone 42, short-range communications 44 and other device subsystems 46. The processor 26 interacts with the touch-sensitive overlay 14 via the electronic resistive touch screen controller 20 and the capacitive touch screen controller 22.

Some of the subsystems of the portable electronic device 24 perform communication-related functions, whereas other subsystems may provide "resident" or on-device functions. By way of example, the display device 12 and the touch-sensitive overlay 14 may be used for both communication-related functions, such as entering a text message for transmission over the network 1000, and device-resident functions such as calculator or task list functions.

The portable electronic device 24 can send and receive communication signals over the wireless network 1000 after network registration or activation procedures have been completed. Network access is associated with a subscriber or user of the portable electronic device 24. To identify a subscriber according to the present embodiment, the portable electronic device 24 uses a SIM/RUIM card 48 (i.e. Subscriber Identity Module or a Removable User Identity Module) inserted into a SIM/RUIM interface 50 for communication with a network such as the network 1000. The SIM/RUIM card 48 is a type of conventional "smart card" that can be used to identify a subscriber of the portable electronic device 24 and to personalize the portable electronic device 24, among other things. In the present embodiment the portable electronic device 24 is not fully operational for communication with the wireless network 1000 without the SIM/RUIM card 48. By inserting the SIM card/RUIM 48 into the SIM/RUIM interface 50, a subscriber can access all subscribed services. Services may include: web browsing and messaging such as e-mail, voice mail, Short Message Service (SMS), and Multimedia Messaging Services (MMS). More advanced services may include: point of sale, field service and sales force automation. The SIM/RUIM card 48 includes a processor and memory for storing information. Once the SIM/RUIM card 48 is inserted into the SIM/RUIM interface 50, it is coupled to the processor 26. In order to identify the subscriber, the SIM/RUIM card 48 can include some user parameters such as an International Mobile Subscriber Identity (IMSI). An advantage of using the SIM/RUIM card 48 is that a subscriber is not necessarily bound by any single physical portable electronic device. The SIM/RUIM card 48 may store additional subscriber information for a portable electronic device as well, including datebook (or calendar) information and recent call information. Alternatively, user identification information can also be programmed into the flash memory 34.

The portable electronic device 24 is a battery-powered device and includes a battery interface 52 for receiving one or more rechargeable batteries 54. In at least some embodiments, the battery 54 can be a smart battery with an embedded microprocessor. The battery interface 52 is coupled to a regulator (not shown), which assists the battery 54 in providing power V+ to the portable electronic device 24. Although current technology makes use of a battery, future technologies such as micro fuel cells may provide the power to the portable electronic device 24.

The portable electronic device 24 also includes an operating system 56 and software components 58 to 68 which are described in more detail below. The operating system 56 and the software components 58 to 68 that are executed by the processor 26 are typically stored in a persistent store such as the flash memory 34, which may alternatively be a read-only memory (ROM) or similar storage element (not shown). Those skilled in the art will appreciate that portions of the operating system 56 and the software components 58 to 68, such as specific device applications, or parts thereof, may be temporarily loaded into a volatile store such as the RAM 32. Other software components can also be included, as is well known to those skilled in the art.

The subset of software applications 58 that control basic device operations, including data and voice communication applications, will normally be installed on the portable electronic device 24 during its manufacture. Other software applications include a message application 60 that can be any suitable software program that allows a user of the portable electronic device 24 to send and receive electronic messages. Various alternatives exist for the message application 60 as is well known to those skilled in the art. Messages that have been sent or received by the user are typically stored in the flash memory 34 of the portable electronic device 24 or some other suitable storage element in the portable electronic device 24. In at least some embodiments, some of the sent and received messages may be stored remotely from the portable electronic device 24 such as in a data store of an associated host system that the portable electronic device 24 communicates with.

The software applications can further include a device state module 62, a Personal Information Manager (PIM) 64, and other suitable modules (not shown). The device state module 62 provides persistence, i.e. the device state module 62 ensures that important device data is stored in persistent memory, such as the flash memory 34, so that the data is not lost when the portable electronic device 24 is turned off or loses power.

The PIM 64 includes functionality for organizing and managing data items of interest to the user, such as, but not limited to, e-mail, contacts, calendar events, voice mails, appointments, and task items. A PIM application has the ability to send and receive data items via the wireless network 1000. PIM data items may be seamlessly integrated, synchronized, and updated via the wireless network 1000 with the portable electronic device subscriber's corresponding data items stored and/or associated with a host computer system. This functionality creates a mirrored host computer on the portable electronic device 24 with respect to such items. This can be particularly advantageous when the host computer system is the portable electronic device subscriber's office computer system.

The portable electronic device 24 also includes a connect module 66, and an information technology (IT) policy module 68. The connect module 66 implements the communication protocols that are required for the portable electronic device 24 to communicate with the wireless infrastructure and any host system, such as an enterprise system, that the portable electronic device 24 is authorized to interface with.

The connect module 68 includes a set of APIs that can be integrated with the portable electronic device 24 to allow the portable electronic device 24 to use any number of services associated with the enterprise system. The connect module 66 allows the portable electronic device 24 to establish an end-to-end secure, authenticated communication pipe with the host system. A subset of applications for which access is provided by the connect module 66 can be used to pass IT policy commands from the host system to the portable electronic device 24. This can be done in a wireless or wired manner. These instructions can then be passed to the IT policy module 68 to modify the configuration of the device 24. Alternatively, in some cases, the IT policy update can also be done over a wired connection.

Other types of software applications can also be installed on the portable electronic device 24. These software applications can be third party applications, which are added after the manufacture of the portable electronic device 24. Examples of third party applications include games, calculators, utilities, etc.

The additional applications can be loaded onto the portable electronic device 24 through at least one of the wireless network 1000, the auxiliary I/O subsystem 36, the data port 38, the short-range communications subsystem 44, or any other suitable device subsystem 46. This flexibility in application installation increases the functionality of the portable electronic device 24 and may provide enhanced on-device functions, communication-related functions, or both. For example, secure communication applications may enable electronic commerce functions and other such financial transactions to be performed using the portable electronic device 24.

The data port 38 enables a subscriber to set preferences through an external device or software application and extends the capabilities of the portable electronic device 24 by providing for information or software downloads to the portable electronic device 24 other than through a wireless communication network. The alternate download path may, for example, be used to load an encryption key onto the portable electronic device 24 through a direct and thus reliable and trusted connection to provide secure device communication.

The data port 38 can be any suitable port that enables data communication between the portable electronic device 24 and another computing device. The data port 38 can be a serial or a parallel port. In some instances, the data port 38 can be a USB port that includes data lines for data transfer and a supply line that can provide a charging current to charge the battery 54 of the portable electronic device 24.

The short-range communications subsystem 44 provides for communication between the portable electronic device 24 and different systems or devices, without the use of the wireless network 1000. For example, the short-range communications subsystem 44 may include an infrared device and associated circuits and components for short-range communication. Examples of short-range communication standards include standards developed by the Infrared Data Association (IrDA), Bluetooth, and the 802.11 family of standards developed by IEEE.

In use, a received signal such as a text message, an e-mail message, or web page download is processed by the communication subsystem 28 and input to the processor 26. The processor 26 then processes the received signal for output to the display device 12 or alternatively to the auxiliary I/O subsystem 36. A subscriber may also compose data items, such as e-mail messages, for example, using the touch-sensitive overlay 14 on the display device 12 that form part of the touch screen display 10, and possibly the auxiliary I/O subsystem 36. The auxiliary I/O subsystem 36 may include devices such as: a mouse, track ball, infrared fingerprint detector, or a roller wheel with dynamic button pressing capability. A composed item may be transmitted over the wireless network 1000 through the communication subsystem 28.

For voice communications, the overall operation of the portable electronic device 24 is substantially similar, except that the received signals are output to the speaker 40, and signals for transmission are generated by the microphone 42. Alternative voice or audio I/O subsystems, such as a voice message recording subsystem, can also be implemented on the portable electronic device 24. Although voice or audio signal output is accomplished primarily through the speaker 40, the display device 12 can also be used to provide additional information such as the identity of a calling party, duration of a voice call, or other voice call related information.

Referring again to Figures 1 and 2, the touch screen display 10 includes the display device 12 and the touch-sensitive overlay 14 disposed on the display device 12. Those skilled in the art will appreciate that the touch-sensitive overlay 14 includes a number of layers. These layers include, for example, a rigid substrate 70 of suitable material such as glass or acrylic and the inner touch sensor layer 16 that includes a resistive circuit layer with a conductive coating of suitable material such as Indium Tin Oxide (ITO), a suitable transparent conductive polymer, or any other suitable transparent conductive material, the outer touch sensor layer 18 that also includes a resistive circuit layer with a conductive coating of suitable material such as ITO, transparent conductive polymer or any other suitable material, and a protective cover 72 such as a polyester film. The inner touch sensor layer 16 is deposited on the rigid substrate 70 while the outer touch sensor layer 18 is deposited on the protective cover 72. The inner touch sensor layer 16 and outer touch sensor layer 18 are separated by an air gap and insulating dots 74. The outer touch sensor layer 18 and the protective cover 72 are flexible for flexing to cause contact between the two ITO (or other suitable material) coatings when a force is applied to the protective cover 72 of the touch screen display 10 by, for example, a user pressing on the protective cover.

It will also be appreciated that the resistive touch screen display 10 shown in Figure 1 is a five wire resistive touch screen display. Thus, the inner touch sensor layer 16 includes opposing x+ and x- and opposing y+ and y- bus bars 76, 78, respectively, and the outer touch sensor layer 18 includes a single bus bar 80. The inner and outer touch sensor layers 16, 18 therefore act as a voltage divider and voltage probe, respectively.

When pressed by a finger or a stylus, for example, the outer touch sensor layer 18 contacts the inner touch sensor layer 16. A differential voltage is applied across the inner touch sensor layer 16 via the opposing x bus bars 76 and the voltage at the point of contact is measured by the outer touch sensor layer 18 via the bus bar 80. A differential voltage is then applied across the inner touch sensor layer 16 via the opposing y bus bars 78 and the voltage at the point of contact is measured by the outer touch sensor layer 18 via the bus bar 80. The position of contact between the inner touch sensor layer 16 and outer touch sensor layer 18 and thus, the position of touch of the finger or stylus, is determined based on the measured voltages.

The resistive touch screen controller 20 drives the voltage applied to the inner touch sensor layer 16 in five wire embodiment shown in Figure 1 and receives the voltages from the outer touch sensor layer 18 for determination of the position of touch by the processor 26.

As indicated above, the outer touch sensor layer 18 is also connected to a capacitive touch screen controller via the bus bar 80 for conducting a continuous electrical current across the touch sensor layer 16 and detecting a change in the capacitance as a result of capacitive coupling between the finger of a user, or a conductive stylus held by a user, and the outer touch sensor layer 18. Thus, the change in capacitance acts as a signal to the electronic capacitive touch screen controller 22, which senses the touch or near touch, on the touch screen display 10.

When a user places a finger, or other conductive object held in the bare hands of the user, on the touch screen display without applying sufficient force to cause the two touch sensor layers to contact each other, capacitive coupling of the finger or conductive object occurs through the protective cover 72, resulting in a signal at the capacitive touch screen controller 22. Capacitive coupling also occurs through the protective cover 72 and through a small air gap. Thus, capacitive coupling occurs, resulting in a signal being sent to the capacitive touch screen controller 22, when the finger or other conductive object (held in the bare hand of a user) approaches the surface of the protective cover 72 and when contacting the protective cover, prior to sufficient force being applied to the protective cover to force the two touch sensor layers into contact with each other. The sensitivity of the capacitive touch screen controller 22 can therefore be set to detect an approaching finger (or other conductive object) at a small distance away from the protective cover 72 of, for example, nine millimeters or less. In the present embodiment, the location of approach is not determined. However, the approach of a finger or other conductive object that is proximal the outer touch sensor layer 18 is determined. Thus, the outer touch sensor layer 18 and the capacitive touch screen controller 22 act to detect proximity, detecting a finger or conductive object proximal the surface of the protective cover 72.

In use, a change in the output of the portable electronic device 24 can occur in response to determination of a conductive object proximal the touch screen display. The change in the output can be dependent on many factors such as the application being executed at the time of determination or the device state or mode.

Determination of an approaching finger or other suitable object as a result of capacitive coupling occurs prior to the outer touch sensor layer 18 being forced into contact with the inner touch sensor layer 16. Thus, capacitive coupling is determined prior to determination of a point of contact of the two touch sensor layers of the resistive touch screen. Resistive touch sensing does not affect the capacitive touch sensing and during resistive touch measurement, capacitive touch sensing is inactive. Therefore, the capacitive and resistive functions of the touch screen do not interfere with each other.
The capacitive controller 22 is connected to the bus bar 80 in the five wire resistive touch screen display.

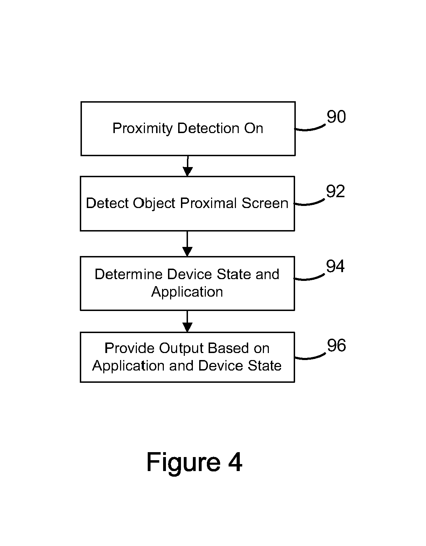

Referring now to Figure 4, there is shown a flow chart illustrating steps in a method of controlling an electronic device such as the portable electronic device 90 with the touch screen display 10 as described herein. At step 90, proximity detection is turned on, for example, by turning on the portable electronic device 24. Thus, electrical current is conducted across the touch sensor layer 16 for the detection of any changes in capacitance.

At step 92 an object is detected proximal the touch screen display 10 as a result of capacitive coupling between the object and the touch sensor layer 16. It will be appreciated that the object detected is a user's finger or a conductive stylus or other conductive object held in a bare hand of the user. As described above, the sensitivity of the capacitive touch screen controller 22 permits detection of an approaching object prior to contact with the touch screen display 10.

Upon determination of an object approaching or proximal the touch screen device, the device state is determined including the active application (step 94). Thus, it is determined if the LCD display device 12 is on (is a displaying a screen) or if the LCD display device is off (in a blacked-out state) which can occur, for example, for saving power in response to lack of user interaction by way of input over a period of time. Any active application with, for example, a GUI displayed on the LCD display device 12, is also determined.

An output is provided based on the device state and active application as determined at steps 94 and 96 (step 96).

In one example, the portable electronic device 24 is on and the proximity detection is therefore active (step 90). Upon detection of an approaching object (step 92), the LCD display device is determined to be off (in a blacked out state). Thus, there is no active application on the portable electronic device 24. In response, the display device 12 is turned on to provide a display screen on the LCD display device 12 (step 96).

In another example, the portable electronic device 24 is on and the proximity detection is therefore active (step 90). Upon detection of an approaching object (step 92), the LCD display device is determined to be on and the cellular telephone application is determined to be active on the portable electronic device 24 and a call is has been placed. In response, the display device 12 is turned off (blacked out) to save power (step 96). Thus, the display device 12 is turned off as the user puts the portable electronic device 24 near his or her face to engage in the telephone call.

The above examples are provided for exemplary purposes only as other examples are possible. For example, in response to determination of an object approaching the touch screen display 10, virtual input can be provided by way of, for example, a button or buttons for user input based on the active application on the portable electronic device 24. Furthermore, the output can be in the form of a sound emitted from the speaker 40, or any other suitable output. This can be useful in providing timely tactile feedback, for example.

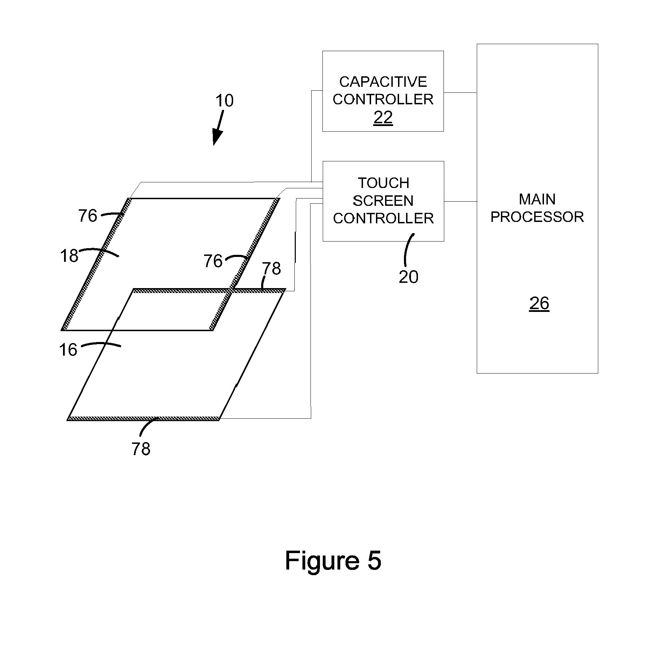

Reference is now made to Figure 5 which shows a block diagram of components of a touch screen display according another embodiment. The present embodiment is similar to that described above in relation to Figure 1 with the exception that the resistive touch screen display 10 is a four wire resistive touch screen display 10, rather than a five wire resistive touch screen display. Thus, in the present embodiment, the inner touch sensor layer 16 includes opposing y+ and y- bus bars 78 and the outer touch sensor layer 18 includes opposing x+ and x- bus bars 76. It will be appreciated that when the inner and outer touch sensor layers 16, 18 contact each other as a result of a user touch with sufficient force, the x position of the touch on the touch screen display 10 is determined as voltage is applied across the x+ and x- bus bars and the voltage at the point of contact is measured by the y+ and y- bus bars. Similarly, the y position of the touch on the touch screen display 10 is determined as voltage is applied across the y+ and y- bus bars and the voltage at the point of contact is measured by the x+ and x- bus bars.

The resistive touch screen controller 20 drives the voltage applied to the inner and outer touch sensor layers 16, 18, respectively, and the respective voltages at the position of touch is measured at the resistive touch screen controller 20 for determination of the position of touch by the processor 26.

As indicated above, the outer touch sensor layer 16 is also connected to a capacitive touch screen controller 22 via one of the bus bars (a reference bus bar) for conducting an electrical current across the touch sensor layer 16 and detecting a change in the capacitance as a result of capacitive coupling between the finger of a user, or a conductive stylus held by a user, and the outer touch sensor layer 18. Thus, the change in capacitance acts as a signal to the electronic capacitive touch screen controller 22, which senses the touch or near touch, on the touch screen display 10.

As in the first-described embodiment, capacitive coupling of a finger, or conductive object, occurs through the protective cover 72, resulting in a signal at the capacitive touch screen controller 22. Capacitive coupling also occurs through the protective cover 72 and through a small air gap. Thus, capacitive coupling occurs, resulting in a signal being sent to the capacitive touch screen controller 22, when the finger or other conductive object (held in the bare hand of a user) approaches the surface of the protective cover 72, and when in contact with the protective cover, prior to sufficient force being applied to the protective cover to force the touch sensor layers into contact with each other. The sensitivity of the capacitive touch screen controller 22 can again be set to detect an approaching finger (or other conductive object) at a small distance away from the protective cover.

While the embodiments described herein are directed to particular implementations of the touch screen display and the portable electronic device, it will be understood that modifications and variations to these embodiments are within the scope and sphere of the present application. For example, the embodiments shown in Figures 1 and 5 depict five and four wire resistive touch screens, respectively. It will be appreciated that other touch screens are possible such as seven wire or eight wire touch screens. Although described as two separate controllers, it is contemplated that the capacitive controller and the resistive touch screen controller can be embodied on a single controller integrated circuit.

It will also be appreciated that the size and shape of many of the features can differ while still providing the same function. Many other modifications and variations may occur to those skilled in the art. All such modifications and variations are believed to be within the sphere and scope of the present application.

## Claims

1. A touch screen display comprising:
a display device;
a resistive touch-sensitive overlay disposed on the display device and comprising a pair of touch-sensor layers separated by a gap;
a resistive touch screen control component connected to each of the pair of touch-sensor layers for determining a position of a touch event on the touch-sensitive overlay; and
a capacitive control component connected to an outer one of the pair of touch-sensor layers for receiving input for determining changes resulting from capacitive coupling with the outer one of the pair of touch-sensor layers.

2. The touch screen display according to claim 1, wherein the resistive touch screen control component comprises a resistive touch screen controller and the capacitive control component comprises a capacitive controller.

3. The touch screen display according to claim 1 or claim 2, further comprising a host processor connected to the resistive touch screen control component and the capacitive control component

4. The touch screen display according to any one of the preceding claims, wherein the pair of touch-sensor layers comprise layers of Indium Tin Oxide 'ITO', each disposed on a respective substrate.

5. The touch screen display according to any one of the preceding claims, wherein the outer one of the pair of touch-sensor layers and the capacitive control component are configured to determine capacitive changes resulting from a conductive object proximal the resistive touch-sensitive overlay.

6. The touch screen display according to any one of claims 1 to 4, wherein the outer one of the pair of touch-sensor layers and the capacitive control component are configured to determine capacitive changes resulting from a conductive object proximal but spaced from the resistive touch-sensitive overlay by an air gap.

7. The touch screen display according to any one of the preceding claims, wherein an outer touch surface comprises a protective cover layer disposed on the outer one of the touch-sensor layers.

8. The touch screen display according to any one of the preceding claims, wherein the resistive touch-sensitive overlay comprises a 4-wire resistive touch-sensitive overlay.

9. The touch screen display according to any one of claims 1 to 7, wherein the resistive touch-sensitive overlay comprises a 5-wire resistive touch-sensitive overlay.

10. An electronic device comprising:
a base;
a touch screen display according to any one of claims 1 to 9 connected to the base; and
a processor connected to the resistive touch screen control component and the capacitive control component and the display device for providing a graphical user interface.

11. A method of controlling an electronic device having a resistive touch screen display, the method comprising:
determining an object is proximal the touch screen display as a result of capacitive coupling between the object and an outer touch-sensor layer of the touch screen display; and
effecting a change in the output of the portable electronic device in response to determining the object is proximal the touch screen display.

12. The method according to claim 11, wherein effecting the change in the output comprises changing an output displayed on the resistive touch screen display.

13. The method according to claim 11 or claim 12, wherein said determining comprises determining the object is proximal the touch screen display when the object is spaced from the touch screen display by an air gap.

14. A computer readable storage storing program code which, when executed by a processor in a computing device, causes the computing device to perform the steps of the method of any one of claims 11 to 13.

## Amended claims

### Amended claims in accordance with Rule 137(2) EPC.

**1.** A touch screen display (10) comprising:
a display device (12);
a resistive touch-sensitive overlay (14) disposed on the display device (12) and comprising a pair of touch-sensor layers (16, 18) separated by a gap;
a resistive touch screen control component (20) connected to each of the pair of touch-sensor layers (16, 18) for determining a position of a touch event on the touch-sensitive overlay (14);
a capacitive control component (22) connected to only the outer one (18) of the pair of touch-sensor layers (16, 18) for receiving input for determining changes resulting from capacitive coupling with the outer one (18) of the pair of touch-sensor layers (16, 18); and
a processor (26) connected to the display device (12), the resistive touch screen control component (20) and the capacitive control component (22) for communicating therewith, the processor (26) being configured to inactivate determination of changes resulting from capacitive coupling with the outer one (18) of the pair of touch sensor layers (16, 18) during determination of the position of a touch event on the touch-sensitive overlay (14) via said resistive touch screen control component (20) .

**2.** The touch screen display according to claim 1, wherein the resistive touch screen control component (20) comprises a resistive touch screen controller and the capacitive control component (22) comprises a capacitive controller.

**3.** The touch screen display (10) according to claim 1 or claim 2, further comprising a host processor (26) connected to the resistive touch screen control component (20) and the capacitive control component (22).

**4.** The touch screen display (10) according to any one of the preceding claims, wherein the outer one (18) of the pair of touch-sensor layers (16, 18) and the capacitive control component (22) are configured to determine capacitive changes resulting from a conductive object proximal the resistive touch-sensitive overlay (14).

**5.** The touch screen display (10) according to any one of claims 1 to 3, wherein the outer one (18) of the pair of touch-sensor layers (16, 18) and the capacitive control component (22) are configured to determine capacitive changes resulting from a conductive object proximal but spaced from the resistive touch-sensitive overlay (14) by an air gap.

**6.** The touch screen display (10) according to any one of the preceding claims, wherein an outer touch surface comprises a protective cover layer (72) disposed on the outer one (18) of the touch-sensor layers (16, 18).

**7.** The touch screen display (10) according to any one of the preceding claims, wherein the resistive touch-sensitive overlay (14) comprises a 4-wire resistive touch-sensitive overlay.

**8.** The touch screen display (10) according to any one of claims 1 to 6, wherein the resistive touch-sensitive overlay (14) comprises a 5-wire resistive touch-sensitive overlay.

**9.** An electronic device comprising (24):
a base;
a touch screen display (10) according to any one of claims 1 to 8 connected to the base; and
a processor (24) connected to the resistive touch screen control component (20) and the capacitive control component (22) and the display device (12) for providing a graphical user interface.
